Europäisches Patentamt

European Patent Office

Office européen des brevets

(11) Veröffentlichungsnummer: **0 048 856**
**A2**

# EUROPÄISCHE PATENTANMELDUNG

(21) Anmeldenummer: 81107145.5

(22) Anmeldetag: 10.09.81

(51) Int. Cl.³: **H 01 J 3/00**, H 01 J 37/04

(30) Priorität: 29.09.80 DE 3036735

(43) Veröffentlichungstag der Anmeldung: **07.04.82**
**Patentblatt 82/14**

(84) Benannte Vertragsstaaten: **DE FR GB NL**

(71) Anmelder: **SIEMENS AKTIENGESELLSCHAFT Berlin und München, Postfach 22 02 61, D-8000 München 22 (DE)**

(72) Erfinder: **Feuerbaum, Hans-Peter, Dipl.-Phys., Tucholskystrasse 22, D-8000 München 83 (DE)**
Erfinder: **Weyl, Reinhard, Dr., Waldstrasse 16, D-8019 Assling (DE)**

(54) Elektrode zur Stahlaustastung in einem Elektronenstrahlerzeugungssystem.

(57) Eine Elektrode (5) zur Strahlaustastung, die einfach zu bedienen ist, zuverlässig ist und kurze Pulse ermöglicht, wird auf einer annähernden Äquipotentialfläche angeordnet, wobei diese annähernde Äquipotentialfläche im Durchlaßbetrieb nahe dem Kathodenpotential liegt.

ACTORUM AG

0048856

SIEMENS AKTIENGESELLSCHAFT

Berlin und München

Unser Zeichen

VPA   80 P 7 1 5 7 E

**Elektrode zur Strahlaustastung in einem Elektronenstrahlerzeugungssystem**

Die Erfindung betrifft eine Elektrode zur Strahlaustastung in einem Elektronenstrahlerzeugungssystem.

Hochfrequente Signalverläufe z.B. in integrierten Schaltungen werden mit einem Elektronenstrahl-Meßgerät nach dem Sampling-Prinzip gemessen. Dabei wird ein Elektronenstrahl in einem Strahlaustastsystem pulsförmig unterbrochen. Zweck der Erfindung ist die Erzeugung dieser Elektronenpulse.

Bisher wurden zur schnellen Strahlaustastung (Pulsbreite < 100 ns) elektrostatische Systeme, z.B. Plattenkondensatoren oder Wanderwellenstrukturen verwendet. Zur Erzeugung von kurzen Pulsbreiten ( < 10 ns) müssen diese Systeme eine möglichst hohe Ablenkempfindlichkeit haben, die jedoch nur durch einen geringen Abstand (100 $\mu$m - 200 $\mu$m) zwischen den Ablenkstrukturen erreicht werden kann. Beim Betrieb eines solchen Austastsystems treten Probleme bezüglich der Störsicherheit und der Handhabung auf.

a) Infolge des geringen Abstandes der Ablenkstrukturen trifft der Elektronenstrahl zum Teil auf die Ablenkstrukturen. Die dadurch verursachte Kontamination kann die Funktion des Austastsystems empfindlich stören.

b) Durch den streifenden Einfall des Elektronenstrahls können Elektronen im Austastsystem so reflektiert werden, daß sie außerhalb des fokussierten Elektronenstrahls

My 1 Kow / 25.9.1980

0048856

80 P 7157 E

auf die Probe treffen und damit zu Meßfehlern führen.

c) Die Justierung der Kathode wird durch ein im Strahlengang liegendes Austastsystem außerordentlich erschwert. Es ist daher unbedingt erforderlich, vor der Justierung der Kathode den Abstand der Ablenkstrukturen auf mehrere Millimeter zu vergrößern. Nach der Kathodenjustierung muß das Austastsystem wieder an den Elektronenstrahl herangeführt werden.

Ein Strahlaustastsystem nach dem angeführten Stand der Technik ist beschrieben von H.-P. Feuerbaum und J. Otto, "Beam chopper for subnanosecond pulses in scanning electron microscopy", J. Phys. E: Sci. Instrum., Vol. 11, 1978, 529 - 532.

Der Erfindung liegt die Aufgabe zugrunde, eine Elektrode zur Strahlaustastung in einem Elektronenstrahlerzeugungssystem anzugeben, die sehr einfach zu bedienen ist, eine hohe Zuverlässigkeit aufweist und die Erzeugung von sehr kurzen Pulsen erlaubt.

Erfindungsgemäß wird diese Aufgabe dadurch gelöst, daß diese Elektrode auf einer annähernden Äquipotentialfläche angeordnet ist, wobei diese Äquipotentialfläche im Durchlaßbetrieb nahe dem Kathodenpotential liegt, und wobei der Abstand dieser Elektrode zur Kathode und die Öffnung dieser Elektrode von der gleichen Größenordnung sind.

In einer Ausbildung der Erfindung weist diese Elektrode einen Abstand zur Kathode und eine Öffnung in der Größenordnung von jeweils 100 $\mu$m auf.

Vorteilhafterweise wird die Elektrode zur Strahlaustastung in einem Elektronenstrahlerzeugungssystem auf dem Sockel der Kathodenhalterung befestigt. Erfindungsgemäß werden Laufzeiten der Elektronen in der Raumladungswolke vor der Kathode verringert. Das elektrische
Austastsignal wird der auf Hochspannung liegenden
Elektrode zur Strahlaustastung über einen Kondensator
zugeführt.

Die erfindungsgemäße Anordnung bietet folgende Vorteile:

a) Die Strahlaustastung ist weitgehend unabhängig von
der Beschleunigungsspannung des Elektronenstrahls.
b) Die hohe Temperatur in der Nähe der Kathode verhindert
eine Kontamination der Gitterelektrode.
c) Die Pulsbreite des Elektronenstrahls entspricht dem
angelegten elektrischen Signal, da keine Laufzeiten,
wie z.B. in Plattenkondensatoren auftreten.
d) Im Gegensatz zu herkömmlichen Ablenksystemen wird die
Justierung der Elektronenkanone nicht durch die Elektrode
zur Strahlaustastung gestört.
e) Da die Elektrode zur Strahlaustastung auf der Kathodenhalterung befestigt wird, kann das Austastsystem ohne
komplizierte Geräteänderungen in Elektronenkanonen eingesetzt werden.

Die erfindungsgemäße Halterung der Elektrode zur Strahlaustastung auf der Kathodenhalterung erleichtert die
Wartung der Anordnung wesentlich, da die Elektrode zur
Strahlaustastung beim Kathodenwechsel automatisch mit
ausgetauscht wird.

In einer Ausbildung der Erfindung ist die Elektrode zur
Strahlaustastung eine Gitterelektrode mit ansonsten beliebiger Gestalt. In einer anderen Ausbildung der Erfindung ist die Elektrode zur Strahlaustastung eine
Lochblendenelektrode mit rechteckiger, runder oder sonstwie gestalteter Öffnung. Wesentlich bei der Ausbildung der Elektrode zur Strahlerzeugung ist, daß diese Elektrode mit allen ihren Einzelheiten auf der annähernden Äquipotentialfläche angeordnet ist, die im Durchlaßbetrieb nahe dem Kathodenpotential liegt.

Die Erfindung ist in der Zeichnung dargestellt und wird im folgenden näher erläutert.

Figur 1 zeigt einen halbierten Längsschnitt durch das Strahlerzeugungssystem.
Figur 2 zeigt einen Längsschnitt durch das Strahlerzeugungssystem.
Figur 3 zeigt zwei mögliche Ausbildungen der Elektrode zur Strahlaustastung.

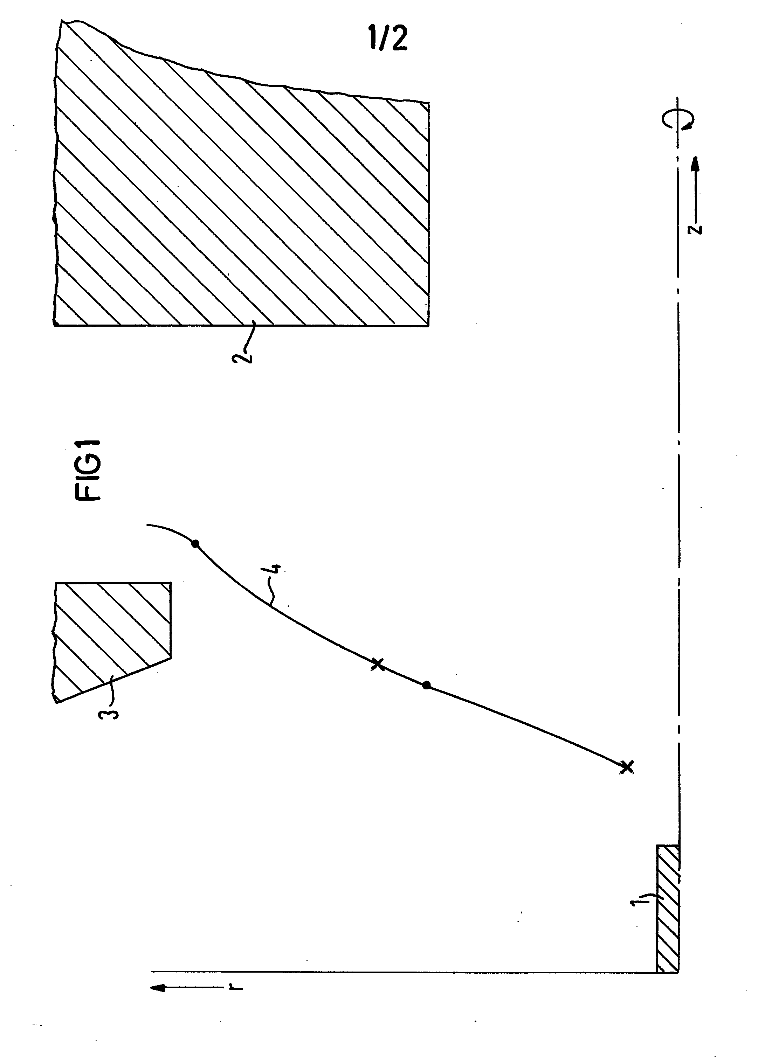

Figur 1 zeigt die Äquipotentiallinie 4 bei einem Elektronenstrahlerzeugungssystem. Grundlage der Erfindung ist die Erkenntnis, daß nahe der Kathode zwischen Kathode, Wehnelt und Anode unter Betriebsbedingungen eine Äquipotentialfläche nahe dem Kathodenpotential existiert, und daß/auf diese Äquipotentialfläche die Elektrode 5, die zur Strahlaustastung in einem Elektronenstrahlerzeugungssystem dient, gelegt wird. Für die Berechnung der in Figur 1 gezeigten Äquipotentiallinie 4 wurden folgende elektronenoptische Verhältnisse in einem für ein Elektronenstrahl-Meßgerät typischen Strahler bei den üblichen Betriebsbedingungen angenommen: Das Potential der Anode 1 ist 900 V, die Wehnelt-Elektrode 3 liegt auf dem Null-Potential und das Potential der Anode 2 ist 3350 V. Die Äquipotentiallinie 4 wurde so gelegt, daß ihr Potential 900 V ist und damit mit dem Potential der Kathode 1 übereinstimmt. Die Elektrode 5, die zur Strahlaustastung dient, wird im allgemeinen nur einen Teil der Äquipotentialfläche, die durch die Äquipotentiallinie 4 definiert ist, einnehmen. Die Form der Elektrode 5 wird nach elektronenoptischen Erfordernissen gestaltet. Wichtig ist nur, daß alle Einzelheiten bzw. Einzelelemente der Elektrode 5, ob sie nun aus verschiedenen Elementen zusammengesetzt ist oder aus einem einzigen Stück gearbeitet ist, ungefähr auf der durch die Äquipotentiallinie 4 definierten Äquipotentialfläche angeordnet sind.

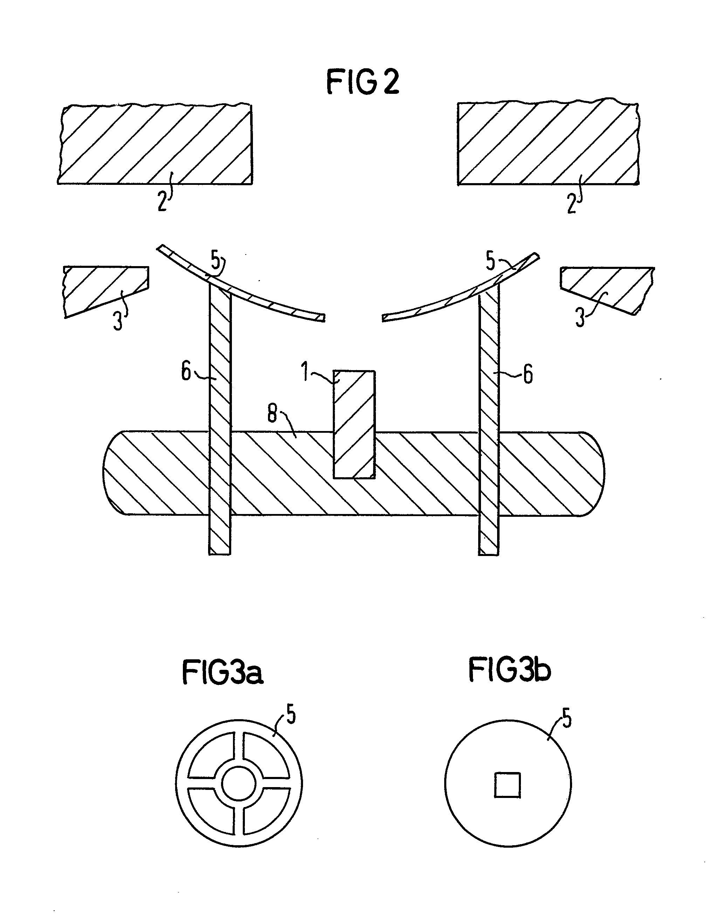

Figur 2 zeigt einen Längsschnitt durch das Strahlerzeugungssystem. Wie zu erkennen ist, befindet sich die Elektrode 5, die zur Strahlaustastung dient, auf einem Teil der in Figur 1 dargestellten Äquipotentiallinie 4. Wenn die in Figur 2 dargestellte Kathode 1 einen Durchmesser von 90 /um aufweist, dann hat die Elektrode 5 einen Abstand von etwa 100 /um zu dieser Kathode 1 und eine Öffnung von wiederum der Größenordnung 100 /um. Die Elektrode 5 ist über eine Halterung 6 auf der Kathodenhalterung 8 montiert. Die Elektrode 5 wird über die elektrisch leitende Halterung 6 gesteuert, wobei diese Halterung 6 durch Bohrlöcher in der Kathodenhalterung 8 geführt wird. Die Kathodenhalterung 8 kann beispielsweise aus einer Porzellanscheibe bestehen, bei der auf der einen Seite die Kathode 1 und die Träger 6 mit der Elektrode 5 befestigt sind und bei der auf der anderen Seite drei Leitungen wegführen, welche zu der in der Figur 2 nicht dargestellten Heizung und zur Steuerung der Elektrode 5 dienen.

Figur 3 zeigt in der Draufsicht zwei mögliche Ausbildungen der Elektrode 5 zur Strahlaustastung. Figur 3a zeigt eine Gitterelektrode und Figur 3b zeigt eine Lochblendenelektrode mit rechteckiger Öffnung. Mit diesen beiden Formen für die Elektrode 5 soll bekräftigt werden, daß im Rahmen dieser Erfindung die Elektrode 5 beliebig ausgebildet werden kann, solange diese Elektrode 5 annähernd auf der Äquipotentialfläche liegt, die durch die

0048856

80 P 7157 E

Äquipotentiallinie 4 definiert ist.

Es wird auch bekräftigt, daß auch eine andere Halterung der Elektrode 5 als die hier näher beschriebene Befestigung auf der Kathodenhalterung im Rahmen dieser Erfindung möglich ist.

Bei der Berechnung der Äquipotentiallinie 4 wurde eine Kathodentemperatur von 2800 K angenommen.

5 Patentansprüche
3 Figuren

0048856

<u>Patentansprüche</u>

1. Elektrode zur Strahlaustastung in einem Elektronenstrahlerzeugungssystem, dadurch g e k e n n z e i c h - n e t , daß diese Elektrode auf einer annähernden Äquipotentialfläche angeordnet ist, wobei diese Äquipotentialfläche im Durchlaßbetrieb nahe dem Kathodenpotential liegt, und wobei der Abstand dieser Elektrode zur Kathode und die Öffnung dieser Elektrode von der gleichen Größenordnung sind.

2. Elektrode zur Strahlaustastung in einem Elektronenstrahlerzeugungssystem nach Anspruch 1, dadurch g e - k e n n z e i c h n e t , daß diese Elektrode einen Abstand zur Kathode und eine Öffnung in der Größenordnung von jeweils 100 $\mu$m aufweist.

3. Elektrode zur Strahlaustastung in einem Elektronenstrahlerzeugungssystem nach Anspruch 1 oder 2, dadurch g e k e n n z e i c h n e t , daß diese Elektrode auf dem Sockel der Kathodenhalterung befestigt ist.

4. Elektrode zur Strahlaustastung in einem Elektronenstrahlerzeugungssystem nach einem der Ansprüche 1 bis 3, dadurch g e k e n n z e i c h n e t , daß die Elektrode eine Gitterelektrode mit ansonsten beliebiger Gestalt ist.

5. Elektrode zur Strahlaustastung in einem Elektronenstrahlerzeugungssystem nach einem der Ansprüche 1 bis 3, dadurch g e k e n n z e i c h n e t , daß die Elektrode eine Lochblendenelektrode mit rechteckiger, runder oder sonstwie gestalteter Öffnung ist.

FIG1

## FIG 2

## FIG3a

## FIG3b